# EUROPEAN PATENT SPECIFICATION

(11) **EP 1 492 157 B1**
(45) Date of publication and mention of the grant of the patent: **23.11.2011**
(21) Application number: 04014391.9
(22) Date of filing: 18.06.2004
(51) Int. Cl.: H01L 21/00, C23C 14/00

(54) **Manufacturing apparatus**
Herstellungsvorrichtung
Appareil de fabrication

(30) Priority: 27.06.2003 JP 2003184139
(43) Date of publication of application: 29.12.2004
(73) Proprietor: Semiconductor Energy Laboratory Co., Ltd., Atsugi-shi, Kanagawa-ken 243-0036 (JP)
(72) Inventor: Sakata, Junichiro, Atsugi-shi, Kanagawa-ken 243-0036 (JP)
(74) Representative: Grünecker, Kinkeldey, Stockmair & Schwanhäusser

(56) References cited:
- EP-A- 0 545 610
- EP-A- 0 665 193
- EP-A- 1 384 796
- WO-A-98/54375
- US-A- 6 110 290
- US-A1- 2002 176 930
- PATENT ABSTRACTS OF JAPAN vol. 018, no. 075 (C-1163), 8 February 1994 (1994-02-08) -& JP 05 285423 A (ASAHI SANAC KK), 2 November 1993 (1993-11-02)

## Description

### BACKGROUND OF THE INVENTION

### 1. Field of the Invention

The present invention relates to a manufacturing apparatus having a film forming apparatus for depositing a material that can be deposited by vapor deposition (hereinafter, referred to as an evaporation material). The present invention relates to a light emitting device having a layer containing an organic compound as a light emitting layer and which is formed by using the manufacturing apparatus, and a manufacturing method thereof. Specifically, the present invention relates to a method (a vapor deposition method) for forming a film by vaporizing an evaporation material from a plurality of evaporation sources disposed to be opposite to a substrate and a manufacturing apparatus.

### 2. Related Art

In recent years, active research on a light emitting device having an EL element as a self-luminous light emitting element has been advanced. The light emitting device is also referred to as an organic EL display or an organic light emitting diode. Since these light emitting devices have characteristics such as high response speed, low voltage, or low power consumption driving suitable for movie display, they attracts an attention for a next generation display including a new generation's cellular phone, a personal digital assistant (PDA), or the like.

An EL element using a layer containing an organic compound as a light emitting layer has a structure in which a layer containing an organic compound (hereinafter, referred to as an EL layer) is sandwiched between an anode and a cathode. Electro luminescence is generated in the EL layer by applying an electric field to the anode and the cathode. Luminescence obtained from the EL element includes luminescence generated in returning to a ground state from a singlet excited state (fluorescence) and luminescence generated in returning to a ground state from a triplet excited state (phosphorescence).

The EL layer has a laminated structure as typified by "a hole transport layer/ a light emitting layer/ an electron transport layer". In addition, EL materials for forming an EL layer are classified broadly into low molecular weight (monomer) materials and high molecular weight (polymer) materials. The low molecular weight materials are deposited using a vapor deposition apparatus.

A conventional vapor deposition apparatus has a substrate holder where a substrate is set, a crucible (or an evaporation boat) encapsulating an EL material (an evaporation material), a shutter for preventing an EL material to be sublimed from ascending, and a heater for heating the EL material in the crucible. The EL material heated by the heater is sublimed and deposited on a rotating substrate. At this time, in order to deposit uniformly, the distance between the crucible and the substrate needs to be 1 m or more.

When an EL layer is formed by vapor deposition using a conventional vapor deposition apparatus or a conventional vapor deposition method, most of the sublimed EL materials are adhered to an inner wall, a shutter or an adherence preventive shield, which is a protective plate for preventing an evaporation material from adhering to an inner wall of a deposition chamber. Therefore, in forming the EL layer, an efficiency of utilizing an expensive EL material is extremely low i.e. about 1% or less and a manufacturing cost of a light emitting device becomes very high.

According to a conventional vapor deposition apparatus, the distance between a substrate and an evaporation source is required to be 1 m or more in order to obtain a film with uniform thickness. Therefore, the vapor deposition apparatus grows in size, and a period required for exhausting each deposition chamber of the vapor deposition apparatus is prolonged, thereby slowing down deposition speed and lowering throughput. In using a large substrate, film thickness easily becomes uneven in a center portion and a marginal portion of a substrate. Further, the vapor deposition apparatus has a structure for rotating a substrate; therefore, there is a limit to the vapor deposition apparatus for handling a large substrate.

In view of the above described problems, the present inventors propose a vapor deposition apparatus (Reference 1: Japanese Patent Laid-Open No. 2001-247959, and Reference 2: Japanese Patent Laid-Open No. 2002-60926) as one method for solving the above problems.
WO98/54375 discloses a vacuum deposition system including a mobile source. This disclosure illustrates a material source within a vacuum chamber, wherein the material source is moveable in a horizontal direction and the panel to be coated is fixed by handling grips.

EP1384796 is a prior art document pursuant to Article 54(3) EPC and discloses an organic film formation apparatus. This disclosure illustrates an injector provided at the position where it is opposed to the substrate held in the substrate holder that is movable in a horizontal direction.

The present invention provides a vapor deposition method as set forth in claim 21 and a vapor deposition apparatus as set forth in claim 1 that promotes an efficiency of utilizing an EL material to reduce a manufacturing cost and is excellent in uniformity or throughput of forming an EL layer. Further, the present invention provides a light emitting device manufactured by the vapor deposition apparatus and the vapor deposition method according to the present invention, and a method for manufacturing the light emitting device.

The present invention also provides a vapor deposition apparatus that prevents a substrate from bending. So, the present invention also provides uniform film thickness even for a whole surface of a large substrate, i.e. 320 mm x 400 mm, 370 mm x 470 mm, 550 mm x 650 mm, 600 mm x 720 mm, 680 mm x 880 mm, 1000 mm x 1200 mm, 1100 mm x 1250 mm, 1150 mm x 1300 mm, or the like.

A larger substrate has larger deposition area; therefore, a larger amount of EL material is required. In the case of a conventional vapor deposition method in which the distance between the substrate and the evaporation source is required to be 1 m or more. Also, an efficiency of utilizing an expensive EL material is extremely low, i.e. about 1% or less, a large amount of EL material is required in a large crucible (or an evaporation boat). Moreover, throughput is lowered since it takes more time to heat the large amount of EL material contained in the large crucible until the deposition rate becomes stable. Further, since substances are not easily heated nor cooled under vacuum, it takes time to cool the EL material. Specifically, when a large amount of EL material is divided into a plurality of crucibles, it becomes difficult to control the deposition rate of each crucible; therefore, it becomes difficult to keep film thickness even. Moreover, even if a plurality of heaters, crucibles, and the like are provided, it is difficult to provide a plurality of identical evaporation sources due to small differences in quality and shape thereof.

In the case of depositing over a large substrate by a conventional face down method, since a center of a substrate bends, the adhesiveness between a substrate and a mask is decreased. Consequently, a problem of a variation of a pattern due to a difference of adhesiveness is caused on the substrate surface.

In the vapor deposition apparatus according to the invention, a substrate (and a mask) is prevented from bending by placing the substrate plane perpendicular to a horizontal surface, and the interval distance between the substrate and the evaporation source is narrowed to typically 50 cm or less, preferably 30 cm or less, more preferably from 5 cm to 15 cm. The efficiency of utilizing an evaporation material and throughput is thus markedly enhanced and one or both of the substrate and the evaporation source are moved. Namely, in a deposition chamber, according to the present invention, an evaporation source holder to which a container encapsulating an evaporation material is set is moved (or shuttled) at a constant speed only in one direction (Z direction, for example) with respect to the substrate. The substrate is transported in a direction (X direction, for example) orthogonal to the movement direction of the evaporation source holder (Z direction) at regular intervals.

Adhesion of particles can be reduced by vertically placing a substrate plane. In addition, a footprint of the vapor deposition apparatus as a whole can be downsized.

A structure of the invention disclosed in this specification is a manufacturing apparatus comprising a film forming apparatus which evaporates an evaporation material from an evaporation source disposed opposite to a substrate to perform deposition over the substrate, wherein a deposition chamber comprises: a moving means (substrate transport mechanism) in which a substrate plane is disposed perpendicular to a bottom face of the deposition chamber and the substrate is moved in the X-axis direction with the substrate kept disposed perpendicularly; an evaporation source; and an elevating means (evaporation source holder movement mechanism) of the evaporation source in the Z-axis direction orthogonal to the X-axis direction, and wherein deposition is performed by repeatedly moving the substrate in the X-axis direction at regular intervals after the evaporation source is moved up and down in the Z-axis direction.

A plurality of evaporation sources may be provided for one deposition chamber in order to enable co-evaporation or multilayer deposition. Another structure of the present invention is a manufacturing apparatus comprising a film forming apparatus which evaporates an evaporation material from an evaporation source disposed opposite to a substrate to perform deposition over the substrate, wherein a deposition chamber comprises: a moving means in which a substrate plane is disposed perpendicular to a bottom face of the deposition chamber and the substrate is moved in the X-axis direction with the substrate kept disposed perpendicularly; a plurality of evaporation sources; and a plurality of movement mechanism of the plurality of evaporation sources in the Z-axis direction orthogonal to the X-axis direction, and wherein co-evaporation or multilayer deposition is performed by repeatedly moving the substrate in the X-axis direction at regular intervals after the plurality of evaporation sources are moved up and down in the Z-axis direction.

A preparatory chamber having a film thickness monitor is preferably provided to connect to the deposition chamber. Another structure of the present invention is a manufacturing apparatus comprising a film forming apparatus which evaporates an evaporation material from an evaporation source disposed opposite to a substrate to perform deposition over the substrate, wherein a deposition chamber comprises: a moving means in which a substrate plane is disposed perpendicular to a bottom face of the deposition chamber and the substrate is moved in the X-axis direction with the substrate kept disposed perpendicularly; an evaporation source; and an elevating means of the evaporation source in the Z-axis direction orthogonal to the X-axis direction, wherein a preparatory chamber in which a film thickness meter is provided is connected to the deposition chamber, and wherein deposition is performed by repeatedly moving the evaporation source up and down in the Z-axis direction and moving the substrate in the X-axis direction at regular intervals after a predetermined deposition rate is obtained in the preparatory chamber.

According to the above structures, a plurality of film thickness meters (i.e. a film thickness meter for a host material, a film thickness meter for a dopant material etc.) may be provided for the preparatory chamber at different distances from the evaporation source.

According to the above structures, a plurality of the preparatory chambers are provided to sandwich the deposition chamber. The evaporation source is moved from one preparatory chamber to another preparatory chamber through the deposition chamber, thereby performing one line of deposition on the vertically placed substrate.

A lifetime of the film thickness monitor can be extended by providing the plurality of the preparatory chambers having the film thickness monitor.

According to each of the above structures, one kind of evaporation material is horizontally discharged from the evaporation source that moves up and down in the Z-axis direction.

According to the present invention, since deposition is performed on a vertically placed substrate, an evaporation material is horizontally discharged under vacuum. Consequently, a container also has a feature that is provided with an evaporation opening (or a guide) on a sidewall. The container has a mechanism for horizontally discharging an evaporation material from the evaporation opening.

Another structure of the present invention is a manufacturing apparatus comprising a film forming apparatus which evaporates an evaporation material from an evaporation source disposed opposite to a substrate to perform deposition over the substrate, wherein an opening for horizontally discharging an evaporation material is provided on a sidewall of a container to be placed in the evaporation source, and a plane with a minimum diameter of the opening is coplanar with an outer surface of the container.

The evaporation source may be changed instead of the container as described above. In that case, the evaporation source also has a feature that is provided with an evaporation opening (or a guide) on a sidewall. The evaporation source has a mechanism for horizontally discharging an evaporation material from the evaporation opening.

Another structure of the present invention is a manufacturing apparatus comprising a film forming apparatus which evaporates an evaporation material from an evaporation source disposed opposite to a substrate to perform deposition over the substrate, wherein an opening for horizontally discharging an evaporation material is provided on a sidewall of the evaporation source, and a plane having a minimum diameter of the opening is coplanar with an outer surface of the evaporation source.

According to the above structure, an area of the opening on the outer surface of the evaporation source is smaller than that on an inner surface of the evaporation source. This prevents a vicinity of the opening from falling in temperature, and prevents the opening from being clogged.

According to the above structure, a container containing an evaporation material to be placed in the evaporation source is surrounded by an upper heater and a lower heater those can be controlled their temperature, respectively. The opening is prevented from being clogged by heating the vicinity of the opening with the upper heater.

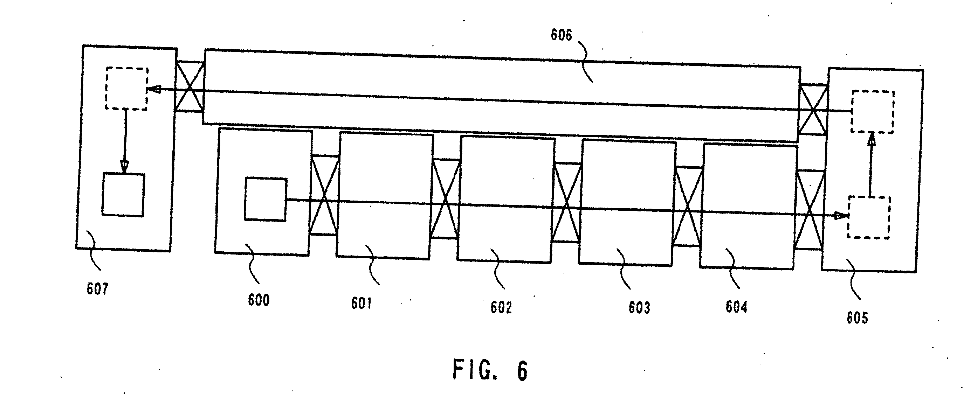

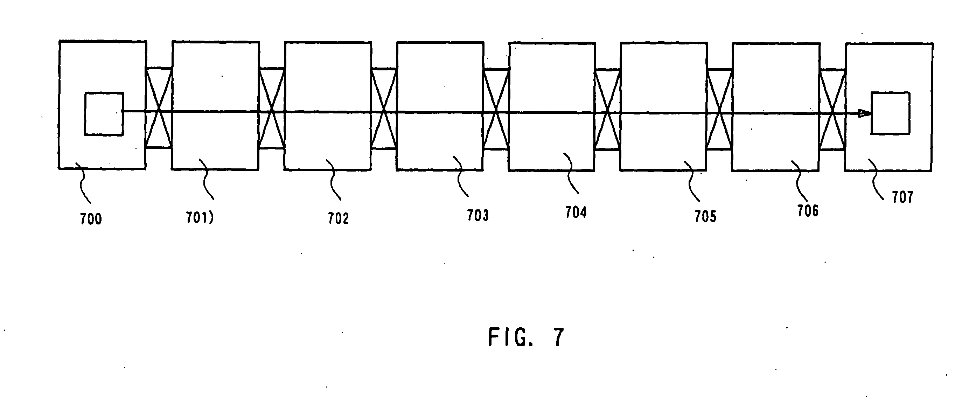

By using a film forming apparatus of the present invention, the manufacturing apparatus can be provided in an in-line manufacturing apparatus to which a loading chamber, a transport chamber, and a deposition chamber are connected in series (examples thereof are shown in FIGS. 6 and 7).

The manufacturing apparatus may be a manufacturing system in which without using a conventional container, typically a brown glass bottle or the like, an EL material is directly contained in a container to be provided for the vapor deposition apparatus and in which deposition is performed after the container is transported in the deposition chamber. An integrated closed system that can prevent impurities from being mixed into an evaporation material refined at a material maker as well as a fully automated manufacturing system that improves throughput can be realized.
These and other objects, features and advantages of the present invention will become more apparent upon reading of the following detailed description along with the accompanied drawings.

### BRIEF DESCRIPTION OF THE DRAWINGS

In the accompanying drawings:
FIGS. 1A and 1B are a perspective view and a cross-sectional view of a film forming apparatus (Embodiment Mode 1);
FIGS. 2A and 2B are cross-sectional views of a container (Embodiment Mode 2);
FIGS. 3A and 3B show co-evaporation (Embodiment Mode 1);
FIGS. 4A and 4B are a top view and a cross-sectional view of a film forming apparatus (Embodiment 1);
FIGS. 5A and 5B are cross-sectional views showing an example of an evaporation source holder (Embodiment 2);
FIG. 6 is a side view of an in-line manufacturing apparatus (Embodiment 3); and
FIG. 7 is a side view of an in-line manufacturing apparatus.

### DETAILED DESCRIPTION OF THE INVENTION

Embodiment modes of the present invention are described hereinafter.

### (Embodiment Mode 1)

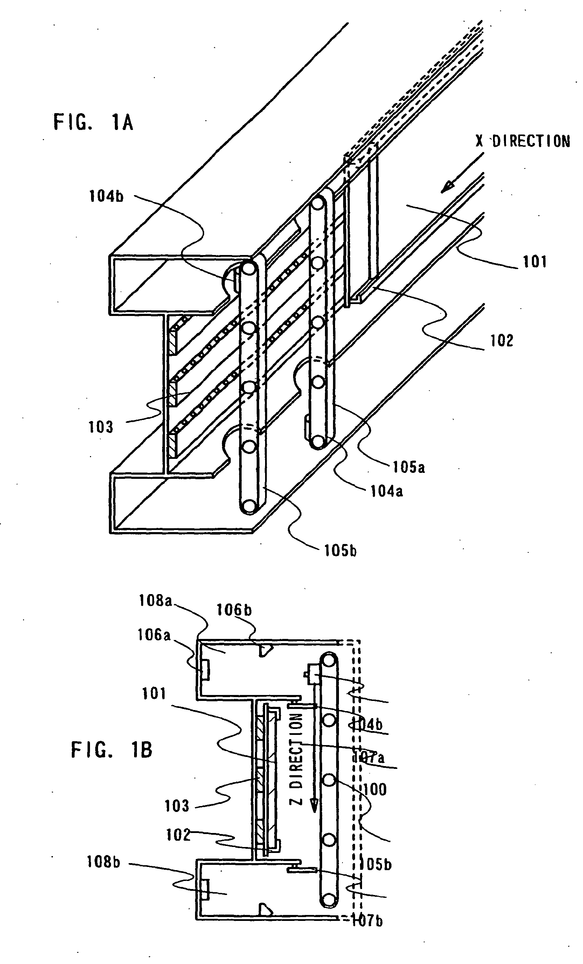

An example of a manufacturing apparatus of the present invention is described with reference to FIGS. 1A and 1B.

FIG. 1A is a perspective view of a vapor deposition apparatus, and FIG. 1B is a cross-sectional view corresponding to FIG. 1A. Reference numeral 100 denotes a deposition chamber; 101, a substrate; 102, a substrate holder; 103, a substrate transport mechanism; 104a and 104b, evaporation source holders; 105a and 105b, evaporation source holder movement mechanisms; 106a and 106b, film thickness monitors; 107a and 107b, shutters; 108a and 108b, preparatory chambers, respectively.

Steps of deposition are described hereinafter.

At first, the deposition chamber 100 and the preparatory chambers 108a and 108b are vacuum-evacuated to vacuum degree of at most 5 x 10⁻³ Torr (0.665 Pa), preferably from 10⁻⁴ to 10⁻⁶ Torr. The deposition chamber 100 and the preparatory chambers 108a and 108b are connected to a vacuum evacuation chamber, and can be vacuumed by vacuum-evacuating or be under atmospheric pressure by bringing in an inert gas after the vacuum evacuation. The above-described vacuum evacuation chamber is provided with a magnetic levitation turbomolecular pump, a cryopump, or a dry pump. The pump makes it possible for the transport chamber connected to each chamber to reach a vacuum level of from 10⁻⁵ to 10⁻⁶ Torr. Reverse diffusion of impurities from the pump side and the evacuation system can be prevented. In order to prevent impurities from being brought into the apparatus, an inert gas such as nitrogen or a rare gas is used as the gas to be brought in. The gas brought into the apparatus has to be a highly pure gas refined by a gas refining machine prior to being brought into the apparatus. Accordingly, a gas refining machine needs to be provided so that a gas is highly purified before it is brought into the vapor deposition apparatus. In this way, oxygen, moisture, and other impurities can be removed from the gas in advance; therefore, these impurities can be prevented from being brought into the apparatus.

A container containing an evaporation material is placed in the evaporation source holder in advance, and is pre-heated (heated to a lower temperature than an initiation temperature for deposition) in the preparatory chamber 108a or 108b by resistance heating.

Subsequently, the substrate 101 is fixed to the substrate holder 102, and is moved into the deposition chamber 100 and to a vicinity of the evaporation source holder movement mechanism 105a by being transported in the X direction in the deposition chamber 100 with the substrate placed vertically by the substrate transport mechanism 103. In the case of selectively performing deposition by using a mask, both the substrate and the mask may be fixed to the substrate holder after aligning the substrate and the mask.

The evaporation source holder is heated in the preparatory chamber to such a temperature that film thickness rate is stabilized, while measuring with the film thickness monitor.

The shutters 107a and 107b are opened, and the evaporation source holder 104a is moved or shuttled in the Z direction by the evaporation source holder movement mechanism 105a to perform deposition. The Z direction is parallel to the substrate placed vertically. Here, a mechanism comprising a rotating belt, a rotating roller, and the like is given as the evaporation source holder movement mechanism 105a; however, the present invention is not particularly limited thereto. An evaporation material is horizontally discharged, and is deposited over a surface of the vertically placed substrate. For example, deposition is performed with the evaporation source holder 104a moving to the deposition chamber 100 from the preparatory chamber 108a. While the evaporation source holder stands by after moving to the preparatory chamber 108b through the deposition chamber 100, the substrate is moved in the X direction at a certain pace. Then, the evaporation source holder 104a is moved to the preparatory chamber 108a through the deposition chamber again. A film thickness rate can be measured in either the preparatory chamber 108a or 108b. Consequently, thickness of a film to be deposited is easily controlled and a lifetime of the film thickness monitor can be extended.

Subsequently, the substrate is moved to a vicinity of the evaporation source holder movement mechanism 105b by the substrate transport mechanism 103. Here, a mechanism comprising a rotating belt, a rotating roller, and the like is given as the substrate transport mechanism 103; however, the present invention is not particularly limited thereto. As described above, the shutters are opened, and the evaporation source holder 104b is moved or shuttled in the Z direction by the evaporation source holder movement mechanism 105b to perform deposition.

In this way, multilayer deposition can be performed. Here, an example of a deposition chamber provided with two evaporation source holders and evaporation source holder movement mechanisms is given; however, the present invention is not particularly limited thereto. Three or more evaporation source holders and evaporation source holder movement mechanisms may be provided to continuously perform deposition.

A shutter different from the shutters 107a and 107b may be provided for the evaporation source holder, or a substrate shutter may be provided between the evaporation source holder and the substrate.

Here, an example in which the substrate transport mechanism is provided on a sidewall of the deposition chamber is given; however, the substrate transport mechanism may be provided on the bottom face of the deposition chamber.

A mechanism for adjusting the interval between the evaporation source holder and the substrate may be provided.

The vapor deposition apparatus shown in FIGS. 1A and 1B can prevent even a large substrate from bending by vertically placing the substrate, and provide uniform film thickness on an entire surface of the substrate. In addition, the vapor deposition apparatus can prevent a mask for the large substrate from bending.

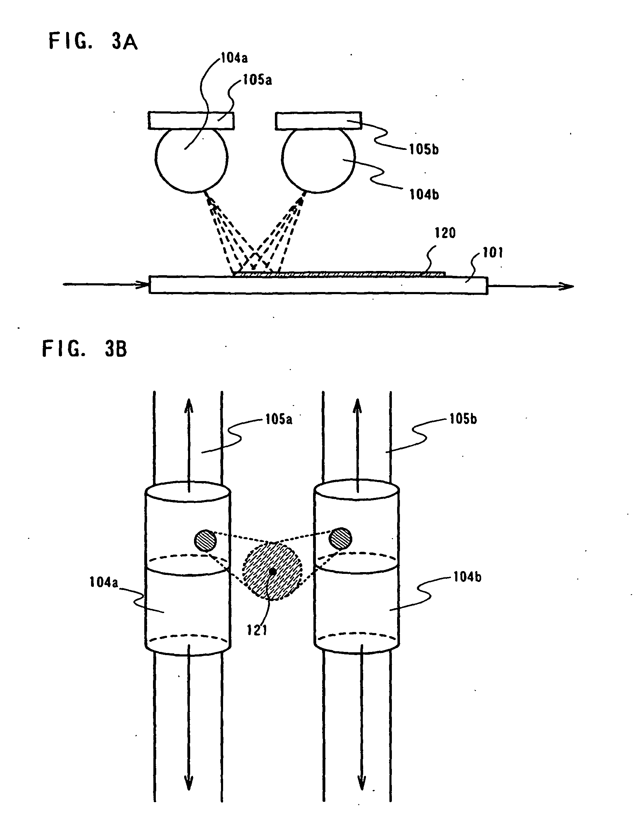

In the case of performing co-evaporation, a plurality of the evaporation source holder movement mechanisms 105a and 105b are disposed at narrower intervals as shown in FIGS. 3A and 3B. Each evaporation center 121 may be concentered on the substrate by appropriately adjusting directions of each evaporation opening to simultaneously perform evaporation.

In FIG. 3A, reference numeral 120 denotes a deposited film obtained by co-evaporation.

FIG. 3A shows a part of a top view around the evaporation source holder in the case of performing co-evaporation, and FIG. 3B shows a side view corresponding thereto. In FIGS. 3A and 3B, the same reference numerals are used in FIGS. 1A and 1B.

### (Embodiment Mode 2)

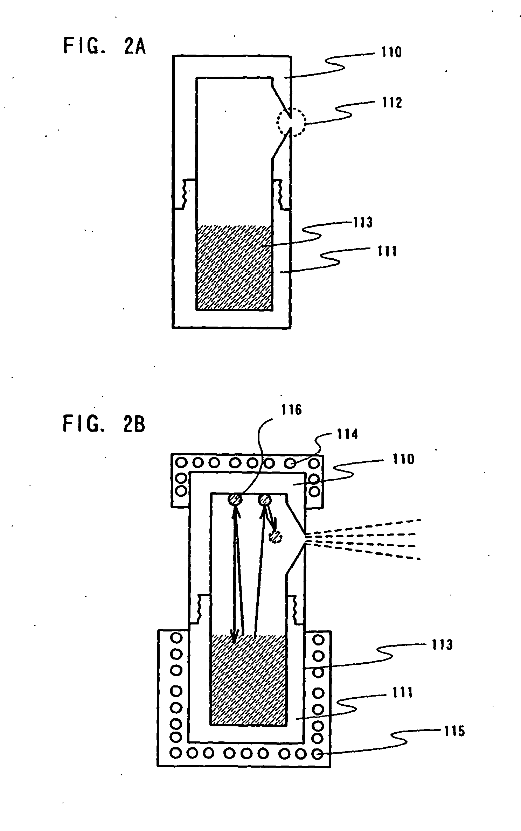

An example of a cross-sectional structure of a container for horizontally discharging an evaporation material is described with reference to FIG. 2A. An evaporation opening 112 is provided on a sidewall of a container and has a characteristic shape, as shown in FIG. 2A.

The container shown in FIG. 2A has a cylindrical shape as a whole and comprises an ,upper part 110 having an opening and a lower part 111. The lower part of container 111 is covered with the upper part of the container 110 after an evaporation material 113 is contained in the lower part 111.

In the case of using a container in which an opening has a tapered shape with a slope slanted from inside to outside of the container and a minimum diameter of the opening is situated on an inner sidewall, surface area of an outer sidewall in contact with an exterior atmosphere becomes large, and the opening easily gets cold.

When the opening easily gets cold, an evaporation material fixes to the opening, and the opening is easily clogged therewith. Therefore, the opening has such a shape that opening area on an inner surface of the container is larger than that on an outer surface, that is, a tapered shape only with a slope slanted from outside to inside. A minimum diameter of the opening is situated on the outer sidewall of the container as shown in FIG. 2A. An edge portion of the opening of the container is made the thinnest part so that the opening is easily heated.

When the container is placed in an evaporation source holder (not shown wholly), a heater (an upper heater 114) for heating the upper part 110 and a heater (an lower heater 115) for heating the lower part 111 are preferably in contact with the container as shown in FIG. 2B. In the case of performing deposition, heating temperature of the upper heater 114 is preferably set equal to or higher than that of the lower heater 115. The upper heater 114 can prevent an evaporation material from fixing to the inner surface of the upper part 110 by heating.

In the case of using the container of the present invention, a large particle is hard to burst out of an opening 112. Specifically, when a large amount of evaporation materials is deposited at once, bumping might occur and a large particle 116 might pop up as shown in FIG. 2B. However, the large particle 116 bumps against an internal ceiling of the container and is returned to its initial position. Alternatively, after the large particle 116 pops up and fixes to the internal ceiling of the container, the particle is vaporized again by the upper heater and is deposited from the internal ceiling to the bottom of the container. In this case, convection is generated with an evaporation material from the internal bottom of the container toward the ceiling and an evaporation material from the internal ceiling of the container toward the bottom to horizontally discharge the evaporation material from the opening 112.

A shape of the opening 112 may be round, elliptical, rectangular, or elongated rectangular.

The heater for heating the upper portion of the container may not be provided if the heater is not particularly required.

In the case of performing co-evaporation, the manufacturing apparatus may have a structure in which a plurality of evaporation source holders are provided for one deposition chamber as shown in FIGS. 3A and 3B. Note that movement mechanisms are provided in order to move the plurality of evaporation source holders, respectively. Directions of evaporation openings may appropriately be adjusted so that each evaporation center 121 of a plurality of evaporation sources is superposed. Alternatively, directions of whole evaporation source holder movement mechanisms can be changed so that each evaporation center of the plurality of evaporation sources is superposed.

Plural types of containers (upper portion) having openings in different positions may be provided and appropriately be replaced to adjust evaporation centers to be superposed.

The present invention comprising the above mentioned structures is described more in detail in the following embodiments.

### (Embodiment)

### [Embodiment 1]

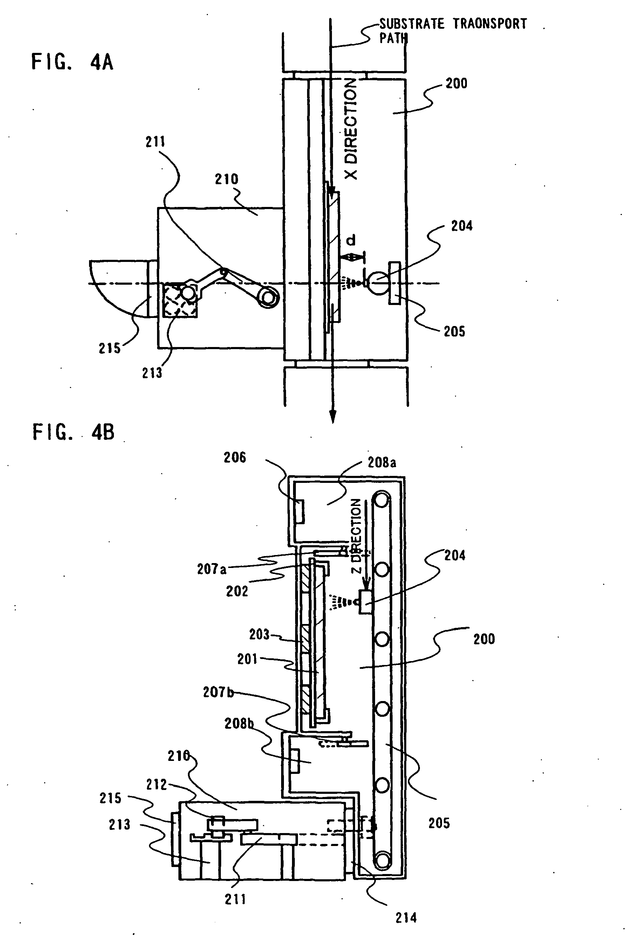

A part of a top view of a manufacturing apparatus is shown in FIG. 4A. Note that illustration of a preparatory chamber is omitted for simplification in FIG. 4A. A deposition chamber 200 is a part of an in-line manufacturing apparatus. Chambers connected adjacent to the deposition chamber 200 are as follows: a similar vertical substrate vapor deposition apparatus; a vertical substrate sputtering apparatus; an alignment chamber for a substrate and a mask; a substrate loading chamber; a substrate unloading chamber; and the like.

Here, an installation chamber 210 connected to the deposition chamber is provided and a container 212 in which an evaporation material is contained is placed in the installation chamber 210, in order to prevent dust from being mixed into the deposition chamber 200 and to maintain a vacuum degree in the deposition chamber 200. Although the installation chamber is repeatedly made under atmospheric pressure and under vacuum, the installation chamber provides a system for consistently maintaining the deposition chamber high vacuum.

At first, the container 212 is carried into the installation chamber 210 through a door 215 and is placed on a container installation board 213. After the installation chamber 210 is vacuum-evacuated to the same level as the deposition chamber 200, a gate 214 is opened. Subsequently, an evaporation source holder 204 is moved to a vicinity of the installation chamber. Then, the container 212 is moved to the evaporation source holder 204 from the container installation board 213 by a vacuum robot 211, and is placed in the evaporation source holder 204. After the container 212 is placed in the evaporation source holder 204, the gate 214 is closed. The evaporation source holder 204 is moved to a preparatory chamber 208a or 208b to start to heat an evaporation material.

As an evaporation material, a low molecular weight organic compound material, in specific, a metal complex such as tris(8-quinolinolate) aluminum (abbreviated to Alq₃), tris(4-methyl-8-quinolinolate) aluminum (abbreviated to Almq₃), bis(10-hydroxybenzo[h]-quinolinato) beryllium (abbreviated to BeBq₂), bis(2-methyl-8-quinolinolate)-(4-hydroxy-biphenylyl)-aluminum (abbreviated to BAlq), bis [2-(2-hydroxyphenyl)-benzooxazolate] zinc (abbreviated to Zn(BOX)₂), or bis [2-(2-hydroxyphenyl)-benzothiazolate] zinc (abbreviated to Zn(BTZ)₂) can be given. Further, an oxadiazole derivative such as 2-(4-biphenyl)-5-(4-tert-butylphenyl)-1,3,4-oxadiazole (abbreviated to PBD) or 1,3-bis[5-(p-tert-butylphenyl)-1,3,4-oxadiazole-2-yl] benzene (abbreviated to OXD-7); an triazole derivative such as 3-(4-tert-butylphenyl)-4-phenyl-5-(4-biphenylyl)-1,2,4-triazole (abbreviated to TAZ) or 3-(4-tert-butylphenyl)-4-(4-ethylphenyl)-5-(4-biphenylyl)-1,2,4-triazole (abbreviated to p-EtTAZ); an imidazol derivative such as 2,2',2"-(1,3,5-benzenetryil) tris[1-phenyl-1H-benzimidazole] (abbreviated to TPBI); or a phenanthroline derivative such as bathophenanthroline (abbreviated to BPhen) or bathocuproin (abbreviated to BCP) can be used in addition to a metal complex.

The substrate 201 is carried into the deposition chamber 200 after an evaporation material is heated and a desired film thickness rate is stably measured with a film thickness monitor 206 provided in the preparatory chamber 208a or 208b. The substrate and a mask (not shown) are previously aligned in a connected chamber, and the substrate is fixed on the substrate holder 202 with being placed vertically. The substrate is carried into the deposition chamber 200 without exposing to atmospheric air. In the deposition chamber, the substrate 201 is moved in an X direction with being placed vertically by a substrate transport mechanism 203.

After moving the substrate to a vicinity of the evaporation source holder 204, shutters 207a and 207b are opened, and the evaporation source holder 204 is moved (or shuttled) in the Z direction from the preparatory chamber 208a (or the preparatory chamber 208b) to the deposition chamber 200. An evaporation material is horizontally discharged from the evaporation source holder 204 and is deposited over the substrate 201 by repeatedly moving (or shuttling) the evaporation source holder 204 in the Z direction and moving the substrate in the X direction.

For example, the evaporation source holder 204 may be moved in the Z direction at a rate of from 30 cm/min to 300 cm/min.

Since the substrate is carried with being placed vertically in the case of using the vapor deposition apparatus shown in FIGS. 4A and 4B, even a large substrate does not bend. Therefore, deposition can be performed even over an entire surface of the large substrate by repeating the above described depositing operations.

In addition, a distance d between the substrate 201 and the evaporation source holder 204 is narrowed to typically 50 cm or less, preferably 30 cm or less, and more preferably from 5 cm to 15 cm, thereby remarkably improving an efficiency of utilizing the evaporation material and throughput.

Here, an example of forming a single layer with one evaporation source holder and one evaporation source holder movement mechanism is given; however, the present invention is not particularly limited thereto. Two or more layers may be laminated by providing two or more evaporation source holders and evaporation source holder movement mechanisms for one deposition chamber.

This embodiment can freely be combined with Embodiment Mode 1 or 2.

### [Embodiment 2]

Since a container is transported with a vacuum robot 211 from an installation chamber 210 and is placed in an evaporation source holder in Embodiment 1, the structure of the evaporation source holder needs to be devised.

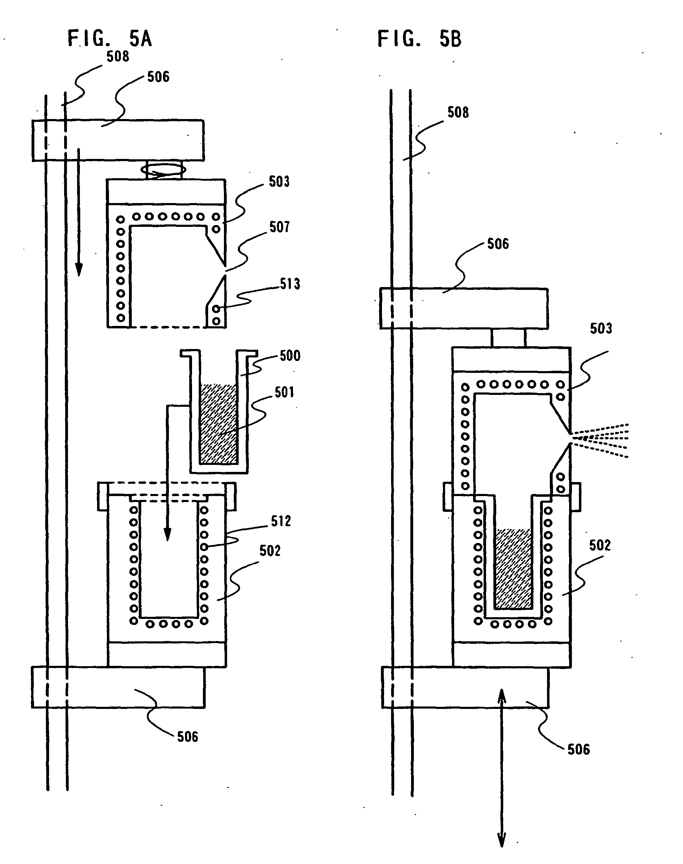

In this embodiment, an example of an evaporation source holder to which the container is transported from the installation chamber 210 with the vacuum robot 211 and is easily placed is described with reference to FIGS. 5A and 5B. FIG. 5A is a cross-sectional view showing a state of the evaporation source holder at the time of placing the container, and FIG. 5B is a cross-sectional view showing a state of the evaporation source holder at the time of deposition.

The evaporation source holder comprises an upper part 502 and a lower part 503 and each part is provided with movement mechanisms 505 and 506, heating mechanisms (an upper heater 513 and a lower heater 512), respectively. The upper and lower parts can move separately.

In this embodiment, a usual crucible can be used for a container 500, and the container has a mechanism for horizontally discharging an evaporation material from an opening 507 provided for the upper part 503. When the opening easily gets cold, an evaporation material fixes to the opening, and the opening is easily clogged therewith. Therefore, the opening has such a shape that opening area on an inner surface of the upper part 503 is larger than that on an outer surface thereof, that is, a tapered shape only with a slope slanted from outside to inside of the upper part 503. A minimum diameter of the opening is situated on the outside of the upper part 503 as shown in FIG. 5A. An edge portion of the opening of the container is made the thinnest part so that the opening is easily heated.

The movement mechanism 505 has a rotating function, and a direction of the opening 507, that is, a direction of discharging the evaporation material can freely be changed.

In the case of using the evaporation source holder of the present invention, a large particle is hard to burst out of the opening 507. Specifically, when a large amount of evaporation materials is deposited at once, bumping might occur and a large particle might pop up. However, the large particle bumps against the internal ceiling of the upper part 503 and is returned to its initial position.

At the time of placing the container (crucible) 500, the upper part 503 is moved upwardly and the container 500 is placed in the lower part 502 by a vacuum robot in an installation chamber as shown in FIG. 5A. Subsequently, the upper part 503 is moved downward and is connected to the lower part 502. In order to firmly connect the upper part 503 to the lower part 502, a hook (not shown) may be provided and the upper part 503 may be rotated to fix the upper part 503.

At the time of deposition, a whole evaporation source holder is moved with the upper part 503 and the lower part 502 being connected to each other as shown in FIG. 5B.

In the case of depositing, heating temperature of the upper heater 513 is preferably set equal to or higher than that of the lower heater 512. Each heater control function is provided for a different portion (for example, a heater control function of the upper heater 513 is incorporated in the movement mechanism 505) to separately control the heaters. The upper heater 513 can also prevent an evaporation material from fixing to the inner surface of the upper part 503 by heating. A problem where an evaporation material goes into and fixes to a connecting portion and the upper and lower parts cannot be separated can also be prevented by heating the upper heater 513 and the lower heater 512 after deposition.

In Embodiment 1, an example of using a rotating belt and a rotating roller as the evaporation source holder movement mechanism is described. However, in this embodiment, an example of using a wheel (not shown) with the use of a rail portion 508 is described as the movement mechanisms 505 and 506. A plurality of wheels are provided inside the movement mechanisms 505 and 506 so that they sandwich the rail portion 508. The evaporation source holder can be moved in the Z direction along the rail portion 508 by driving the wheels.

This embodiment can freely be combined with Embodiment Mode 1 or Embodiment 1.

### [Embodiment 3]

In this embodiment, an example of an in-line manufacturing apparatus suitable for a mass production system is described with reference to FIG. 6.

Gateways of each chamber are connected to form a vacuum transport path in a shape of a loop, and a transport line of a substrate holder is provided therein. A footprint of the manufacturing apparatus as a whole is reduced by transporting a substrate after deposition above a film forming apparatus as shown in FIG. 6.

In FIG. 6, reference numeral 600 denotes a loading chamber; 601, a pretreatment chamber; 602, a deposition chamber (a deposition chamber for depositing a hole transport layer or a hole injection layer); 603, a deposition chamber (a deposition chamber for depositing a light emitting layer); 604, a deposition chamber (a deposition chamber for depositing an electron transport layer or an electron injection layer); 605, a substrate transport chamber having an upward lift mechanism; 606, a substrate transport chamber having a horizontal movement mechanism; and 607, an unloading chamber having a downward lift mechanism. Note that gate valves are provided among each chamber.

The vertical vapor deposition apparatus described in Embodiment Mode 1 or 2, or Embodiment 1 or 2 is used for the deposition chambers 602 to 604.

At first, a substrate on which an anode is formed is placed in the loading chamber 600. A mechanism for vertically placing a substrate is preferable; however, a mechanism for making a horizontally placed substrate vertical in the loading chamber may be provided. Subsequently, the loading chamber is vacuum-evacuated, the gate valve is opened, and then the substrate is carried into the pretreatment chamber 601 by a transport robot or the like. In the pretreatment chamber 601, heat treatment for degasification is performed, a mask (not shown) is aligned, or the substrate is fixed to a substrate holder (not shown). The pretreatment chamber 601 is provided with a feed transport mechanism (not shown) for sequentially transporting the substrate holder and comprises a transport line for intermittently transporting a plurality of substrate holders in a predetermined cycle. Subsequently, the substrate holder to which the substrate is vertically fixed is carried into the deposition chamber 602. In the deposition chamber 602, an evaporation material is horizontally discharged with the evaporation source holder moving in the Z direction to perform deposition onto the vertically placed substrate.

Subsequently, deposition of a film containing an organic compound is sequentially performed in the deposition chambers 603 and 604, as in the deposition chamber 602. A substrate after deposition is carried into the substrate transport chamber 605, and is raised by the upward lift mechanism. Then, the substrate is carried into the unloading chamber 607 through the substrate transport chamber 606. The manufacturing apparatus has a mechanism for taking out the substrate by bringing down the substrate in the unloading chamber 607. Here, although not shown, it is preferable that the unloading chamber is further connected to a chamber for forming a cathode and a chamber for sealing so that the substrate can be transported without being exposed to atmospheric air. In the case of a monochrome light emitting panel, a mask is changed to form a cathode made of a metal material. Thereafter, a light emitting device is completed by sealing with a sealing substrate or a sealing can. In the case of manufacturing a full color light emitting panel, the apparatus shown in FIG. 6 is preferably an apparatus to which respective chambers for R, G, and B are appropriately connected, since the panel needs to be separately colored by changing masks for each color.

The manufacturing apparatus may be laid out as shown in FIG. 7 to have a seriate line in one direction.

In FIG. 7, reference numeral 700 denotes an loading chamber; 701, a pretreatment chamber; 702, a deposition chamber (deposition chamber for depositing a hole transport layer or a hole injection layer); 703, a deposition chamber (deposition chamber for depositing a light emitting layer); 704, a deposition chamber (deposition chamber for depositing an electron transport layer or an electron injection layer); 705, a deposition chamber (deposition chamber for depositing a metal layer serving as a cathode); 706, a deposition chamber (a vertical substrate sputtering chamber for sputtering an inorganic insulating film serving as a protective film); and 707, an unloading chamber.

The vertical vapor deposition apparatus described in Embodiment Mode 1 or 2, or Embodiment 1 or 2 is used for the deposition chambers 702 to 704.

In FIG. 7, sealing is performed by forming a protective film over a cathode in the deposition chamber 706; however, the present invention is not particularly limited thereto. The deposition chamber 706 may be replaced by a chamber for sealing with a sealing substrate or a sealing can.

An in-line manufacturing apparatus in which processes of from forming an organic compound film onto an anode to forming a cathode, further to sealing are fully automated may be completed by combining the manufacturing apparatus shown in FIG. 6 with the manufacturing apparatus shown in FIG. 7.

This embodiment can freely be combined with Embodiment Mode 1 or 2, or Embodiment 1 or 2.

According to the present invention, a manufacturing cost can be reduced by improving an efficiency of utilizing an evaporation material.

Not only are a large substrate and a mask prevented from bending and is a vapor deposition apparatus that provides uniform film thickness over an entire surface of the substrate realized, but also a footprint of a manufacturing apparatus as a whole can be reduced.
This application is based on Japanese Patent Applications serial no. 2003-184139 filed in Japan Patent Office on Jun. 27 in 2003.

## Claims

1. A manufacturing apparatus comprising:
a vapor deposition apparatus having a deposition chamber,
wherein the deposition chamber comprises:
a substrate holder adapted to dispose a substrate perpendicular to a bottom face of the deposition chamber whereby the substrate is moveable in an X-axis direction with the substrate kept disposed perpendicularly;
an evaporation source from which an evaporation material is adapted to be evaporated, the evaporation source being adapted to be positionable disposed opposite to the substrate; and
a movement mechanism for moving the evaporation source in a Z-axis direction orthogonal to the X-axis direction, and
wherein the vapor deposition apparatus is adapted to perform deposition by repeatedly moving the substrate in the X-axis direction at regular intervals after the evaporation source is moved up and down in the Z-axis direction.

2. The manufacturing apparatus according to claim 1, wherein the vapor deposition apparatus is adapted to horizontally discharge the evaporation material from the evaporation source during movement up and down in the Z-axis direction.

3. The manufacturing apparatus according to claim 1, wherein a sidewall of the evaporation source has an opening for horizontally discharging the evaporation material, and
wherein a plane having a minimum diameter of the opening is coplanar with an outer surface of the evaporation source.

4. The manufacturing apparatus according to claim 1, further comprising:
a plurality of the evaporation sources disposed opposite to the substrate; and
a plurality of the movement mechanisms being adapted to move any one of the evaporation sources in a Z-axis direction orthogonal to the X-axis direction,
wherein the vapor deposition apparatus is configured to perform one of co-evaporation and multilayer deposition by repeatedly moving the substrate in the X-axis direction at regular intervals after at least one of the evaporation sources is moved up and down in the Z-axis direction.

5. The manufacturing apparatus according to claim 4, wherein the vapor deposition apparatus is adapted to horizontally discharge one kind of evaporation materials from the evaporation sources that move up and down in the Z-axis direction.

6. The manufacturing apparatus according to claim 4, wherein a sidewall of each evaporation source has an opening for horizontally discharging the evaporation material, and
wherein a plane having a minimum diameter of the opening is coplanar with an outer surface of the each evaporation source.

7. The manufacturing apparatus according to any one of the claims 1 to 3, further comprising:
a preparatory chamber,
wherein the preparatory chamber in which a film thickness meter is provided is connected to the deposition chamber, and
wherein the vapor deposition apparatus is adapted to perform deposition by repeatedly moving the evaporation source up and down in the Z-axis direction and moving the substrate in the X-axis direction at regular intervals after a predetermined deposition rate is measured in the preparatory chamber.

8. The manufacturing apparatus according to claim 7, wherein a plurality of the preparatory chambers are provided to sandwich the deposition chamber.

9. The manufacturing apparatus according to claim 7, wherein the preparatory chamber has a plurality of the film thickness meters at different distances from the evaporation source.

10. The manufacturing apparatus according to claim 1, wherein:
the vapor deposition apparatus is configured for evaporating the evaporation material from the evaporation source,
wherein the evaporation source comprises a container for the evaporation material and a sidewall of the container has an opening for horizontally discharging the evaporation material, and wherein a plane having a minimum diameter of the opening is coplanar with an outer surface of the container.

11. The manufacturing apparatus according to claim 10, wherein the minimum diameter of the opening on an outer surface of the container is smaller than a diameter of the opening on the inner surface of the container.

12. The manufacturing apparatus according to claim 10, wherein the evaporation source is surrounded by an upper heater and a lower heater of which temperatures can be controlled independently.

13. The manufacturing apparatus according to claim 10, wherein a moving direction of the evaporation source is orthogonal to a moving direction of the substrate.

14. The manufacturing apparatus according to any one of the claims 4 to 6, further comprising:
a preparatory chamber,
wherein the preparatory chamber in which a film thickness meter is provided is connected to the deposition chamber, and
wherein the vapor deposition apparatus is adapted to perform deposition by repeatedly moving at least one of the evaporation sources up and down in the Z-axis direction and moving the substrate in the X-axis direction at regular intervals after a predetermined deposition rate is measured in the preparatory chamber.

15. The manufacturing apparatus according to claim 14, wherein a plurality of the preparatory chambers are provided to sandwich the deposition chamber.

16. The manufacturing apparatus according to claim 14, wherein the preparatory chamber has a plurality of the film thickness meters at different distances from the evaporation source.

17. The manufacturing apparatus according to claim 4, wherein:
the vapor deposition apparatus is configured for evaporating the evaporation material from the evaporation sources,
wherein each of the evaporation sources comprises its own container for the evaporation material and each of sidewalls of the containers has an opening for horizontally discharging the evaporation material, and
wherein each of planes having a minimum diameter of the openings is coplanar with an outer surface of the container.

18. The manufacturing apparatus according to claim 17, wherein the minimum diameter of the opening on the outer surface of the container is smaller than a diameter of the opening on an inner surface of the container.

19. The manufacturing apparatus according to claim 17, wherein the evaporation source is surrounded by an upper heater and a lower heater of which temperatures can be controlled independently.

20. The manufacturing apparatus according to claim 17, wherein a moving direction of the evaporation source is orthogonal to a moving direction of the substrate.

21. A method for manufacturing a light-emitting device comprising the steps of:
providing a substrate in a deposition chamber perpendicular to a bottom face of the deposition chamber;
providing an evaporation source having an evaporation material opposite to the substrate
horizontally discharging the evaporation material from the evaporation source to the substrate during movement of the evaporation source up and down in a Z-axis direction; and
moving the substrate in an X-axis direction orthogonal to the Z-axis direction and perpendicular to a normal direction of the substrate,
whereby the substrate is moved repeatedly in the X-axis direction at regular intervals after the evaporation source is moved up and down in the Z-axis direction.

## Patentansprüche

1. Herstellungsvorrichtung, die umfasst:
eine Aufdampfvorrichtung mit einer Abscheidekammer,
wobei die Abscheidekammer umfasst:
einen Substrat-Halter, der so eingerichtet ist, dass er ein Substrat senkrecht zu einer Bodenfläche der Abscheidekammer anordnet, wobei das Substrat in einer X-Achsen-Richtung bewegt werden kann und das Substrat dabei senkrecht angeordnet gehalten wird;
eine Verdampfungsquelle, von der ein Verdampfungsmaterial verdampft wird, wobei die Verdampfungsquelle so eingerichtet ist, dass sie so positioniert werden kann, dass sie dem Substrat gegenüberliegend angeordnet ist; und
einen Bewegungsmechanismus, mit dem die Verdampfungsquelle in einer Z-Achsen-Richtung im rechten Winkel zu der X-Achsen-Richtung bewegt wird, und
wobei die Aufdampfvorrichtung so eingerichtet ist, dass sie Abscheidung durchführt, indem sie das Substrat wiederholt in regelmäßigen Intervallen in der X-Achsen-Richtung bewegt, nachdem die Verdampfungsquelle in der Z-Achsen-Richtung auf- und abbewegt worden ist.

2. Herstellungsvorrichtung nach Anspruch 1, wobei die Aufdampfvorrichtung so eingerichtet ist, dass sie das Verdampfungsmaterial bei Auf- und Abbewegung in der Z-Achsen-Richtung horizontal von der Verdampfungsquelle ausstößt.

3. Herstellungsvorrichtung nach Anspruch 1, wobei eine Seitenwand der Verdampfungsquelle eine Öffnung zum horizontalen Ausstoßen des Verdampfungsmaterials aufweist, und
eine Fläche mit einem minimalen Durchmesser der Öffnung koplanar zu einer Außenfläche der Verdampfungsquelle ist.

4. Herstellungsvorrichtung nach Anspruch 1, die des Weiteren umfasst:
eine Vielzahl der Verdampfungsquellen, die dem Substrat gegenüberliegend angeordnet sind; und
eine Vielzahl der Bewegungsmechanismen, die so eingerichtet sind, dass sie beliebige der Verdampfungsquellen in einer Z-Achsen-Richtung im rechten Winkel zu der X-Achsen-Richtung bewegen,
wobei die Aufdampfvorrichtung so ausgeführt ist, dass sie gleichzeitiges Verdampfen oder mehrschichtiges Abscheiden durchführt, indem sie das Substrat wiederholt in regelmäßigen Intervallen in der X-Achsen-Richtung bewegt, nachdem wenigstens eine der Verdampfungsquellen in der Z-Achsen-Richtung auf- und abbewegt worden ist.

5. Herstellungsvorrichtung nach Anspruch 4, wobei die Aufdampfvorrichtung so eingerichtet ist, dass sie einen Typ Verdampfungsmaterialien horizontal von den Verdampfungsquellen ausstößt, die sich in der Z-Achsen-Richtung auf- und abbewegen.

6. Herstellungsvorrichtung nach Anspruch 4, wobei eine Seitenwand jeder Verdampfungsquelle eine Öffnung zum horizontalen Ausstoßen des Verdampfungsmaterials aufweist, und
eine Fläche mit einem minimalen Durchmesser der Öffnung koplanar zu einer Außenfläche jeder Verdampfungsquelle ist.

7. Herstellungsvorrichtung nach einem der Ansprüche 1 bis 3, die des Weiteren umfasst:
eine Vorbereitungskammer,
wobei die Vorbereitungskammer, in der eine Schichtdicken-Messeinrichtung vorhanden ist, mit der Abscheidekammer verbunden ist, und
die Aufdampfvorrichtung so eingerichtet ist, dass sie Abscheidung durchführt, indem sie die Verdampfungsquelle in der Z-Achsen-Richtung auf- und abbewegt und das Substrat in regelmäßigen Intervallen in der X-Achsen-Richtung bewegt, nachdem eine vorgegebene Abscheiderate in der Vorbereitungskammer gemessen worden ist.

8. Herstellungsvorrichtung nach Anspruch 7, wobei eine Vielzahl der Vorbereitungskammern so vorhanden sind, dass die Abscheidekammer zwischen ihnen eingeschlossen ist.

9. Herstellungsvorrichtung nach Anspruch 7, wobei die Vorbereitungskammer eine Vielzahl der Schichtdicken-Messeinrichtungen in unterschiedlichen Abständen zu der Verdampfungsquelle aufweist.

10. Herstellungsvorrichtung nach Anspruch 1, wobei:
die Aufdampfvorrichtung so ausgeführt ist, dass sie das Verdampfungsmaterial von der Verdampfungsquelle verdampft,
die Verdampfungsquelle einen Behälter für das Verdampfungsmaterial umfasst und eine Seitenwand des Behälters eine Öffnung zum horizontalen Ausstoßen des Verdampfungsmaterials aufweist, und
eine Fläche mit einem minimalen Durchmesser der Öffnung koplanar zu einer Außenfläche des Behälters ist.

11. Herstellungsvorrichtung nach Anspruch 10, wobei der minimale Durchmesser der Öffnung an einer Außenfläche des Behälters kleiner ist als ein Durchmesser der Öffnung an der Innenfläche des Behälters.

12. Herstellungsvorrichtung nach Anspruch 10, wobei die Verdampfungsquelle von einer oberen Heizeinrichtung und einer unteren Heizeinrichtung umgeben ist, deren Temperaturen unabhängig gesteuert werden können.

13. Herstellungsvorrichtung nach Anspruch 10, wobei eine Bewegungsrichtung der Verdampfungsquelle rechtwinklig zu einer Bewegungsrichtung des Substrats ist.

14. Herstellungsvorrichtung nach einem der Ansprüche 4 bis 6, die des Weiteren umfasst:
eine Vorbereitungskammer,
wobei die Vorbereitungskammer, in der eine Schichtdicken-Messeinrichtung vorhanden ist, mit der Abscheidekammer verbunden ist, und
die Aufdampfvorrichtung so eingerichtet ist, dass sie Abscheidung durchführt, indem sie wenigstens eine der Verdampfungsquellen in der Z-Achsen-Richtung auf- und abbewegt und das Substrat in regelmäßigen Intervallen in der X-Achsen-Richtung bewegt, nachdem eine vorgegebene Abscheiderate in der Vorbereitungskammer gemessen worden ist.

15. Herstellungsvorrichtung nach Anspruch 14, wobei eine Vielzahl der Vorbereitungskammern so vorhanden sind, dass die Abscheidekammer zwischen ihnen eingeschlossen ist.

16. Herstellungsvorrichtung nach Anspruch 14, wobei die Vorbereitungskammer eine Vielzahl der Schichtdicken-Messeinrichtungen in unterschiedlichen Abständen zu der Verdampfungsquelle aufweist.

17. Herstellungsvorrichtung nach Anspruch 4, wobei:
die Aufdampfvorrichtung so ausgeführt ist, dass sie das Verdampfungsmaterial von den Verdampfungsquellen verdampft,
jede der Verdampfungsquellen ihren eigenen Behälter für das Verdampfungsmaterial umfasst und jede der Seitenwände der Behälter eine Öffnung zum horizontalen Ausstoßen des Verdampfungsmaterials aufweist, und
jede der Flächen mit einem minimalen Durchmesser der Öffnungen koplanar zu einer Außenfläche des Behälters ist.

18. Herstellungsvorrichtung nach Anspruch 17, wobei der minimale Durchmesser der Öffnung an einer Außenfläche des Behälters kleiner ist als ein Durchmesser der Öffnung an der Innenfläche des Behälters.

19. Herstellungsvorrichtung nach Anspruch 17, wobei die Verdampfungsquelle von einer oberen Heizeinrichtung und einer unteren Heizeinrichtung umgeben ist, deren Temperaturen unabhängig gesteuert werden können.

20. Herstellungsvorrichtung nach Anspruch 17, wobei eine Bewegungsrichtung der Verdampfungsquelle rechtwinklig zu einer Bewegungsrichtung des Substrats ist.

21. Verfahren zum Herstellen einer Lichtemissionsvorrichtung, das die folgenden Schritte umfasst:
Bereitstellen eines Substrats in einer Abscheidekammer senkrecht zu einer Bodenfläche der Abscheidekammer;
Bereitstellen einer Verdampfungsquelle mit einem Verdampfungsmaterial dem Substrat gegenüberliegend,
horizontales Ausstoßen des Verdampfungsmaterials von der Verdampfungsquelle zu dem Substrat bei Auf- und Abbewegung der Verdampfungsquelle in einer Z-Achsen-Richtung;
und
Bewegen des Substrats in einer X-Achsen-Richtung rechtwinklig zu der Z-Achsen-Richtung und senkrecht zu einer Normalrichtung des Substrats,
wobei das Substrat wiederholt in regelmäßigen Intervallen in der X-Achsen-Richtung bewegt wird, nachdem die Verdampfungsquelle in der X-Achsen-Richtung auf- und abbewegt worden ist.

## Revendications

1. Appareil de fabrication comprenant :
un appareil de dépôt en phase vapeur comportant une chambre de dépôt, dans lequel la chambre de dépôt comprend :
un porte-substrat adapté pour disposer un substrat perpendiculairement à une face inférieure de la chambre de dépôt, moyennant quoi le substrat peut être déplacé selon une direction de l'axe X, le substrat étant maintenu disposé perpendiculairement ;
une source d'évaporation à partir de laquelle un matériau d'évaporation peut être évaporé, la source d'évaporation étant adaptée pour être positionnable à l'opposé du substrat ; et
un mécanisme de déplacement pour déplacer la source d'évaporation selon une direction de l'axe Z orthogonale à la direction de l'axe X, et
dans lequel l'appareil de dépôt en phase vapeur est adapté pour effectuer un dépôt en déplaçant de manière répétée le substrat selon la direction de l'axe X à intervalles réguliers après que la source d'évaporation est déplacée vers le haut et vers le bas selon la direction de l'axe Z.

2. Appareil de fabrication selon la revendication 1, dans lequel l'appareil de dépôt en phase vapeur est adapté pour décharger horizontalement le matériau d'évaporation à partir de la source d'évaporation durant les déplacements vers le haut et vers le bas selon la direction de l'axe Z.

3. Appareil de fabrication selon la revendication 1, dans lequel une paroi latérale de la source d'évaporation comporte une ouverture pour décharger horizontalement le matériau d'évaporation, et
dans lequel une surface plane ayant un diamètre au minimum égal à celui de l'ouverture est coplanaire avec une surface externe de la source d'évaporation.

4. Appareil de fabrication selon la revendication 1, comprenant en outre :
une pluralité de sources d'évaporation disposées à l'opposé du substrat ; et
une pluralité des mécanismes de déplacement étant adaptés pour déplacer l'une quelconque des sources d'évaporation selon une direction de l'axe Z orthogonale à la direction de l'axe X,
dans lequel l'appareil de dépôt en phase vapeur est configuré pour effectuer un dépôt soit en co-évaporation, soit en plusieurs couches,
en déplaçant de manière répétée le substrat selon la direction de l'axe X à intervalles réguliers après qu'au moins une des sources d'évaporation est déplacée vers le haut et vers le bas selon la direction de l'axe Z.

5. Appareil de fabrication selon la revendication 4, dans lequel l'appareil de dépôt en phase vapeur est adapté pour décharger horizontalement un des types de matériau d'évaporation à partir des sources d'évaporation qui se déplacent vers le haut et vers le bas selon la direction de l'axe Z.

6. Appareil de fabrication selon la revendication 4, dans lequel une paroi latérale de chaque source d'évaporation comporte une ouverture pour décharger horizontalement le matériau d'évaporation, et
dans lequel une surface plane ayant un diamètre au minimum égal à celui de l'ouverture est coplanaire avec une surface externe de chacune des sources d'évaporation.

7. Appareil de fabrication selon l'une quelconque des revendications 1 à 3, comprenant en outre :
une chambre de préparation,
dans lequel la chambre de préparation, où un dispositif de mesure d'épaisseur de film est pourvu, est connectée à la chambre de dépôt, et
dans lequel l'appareil de dépôt en phase vapeur est adapté pour effectuer un dépôt en déplaçant de manière répétée la source d'évaporation vers le haut et vers le bas selon la direction de l'axe Z et en déplaçant le substrat selon la direction de l'axe X à intervalles réguliers après qu'un taux de dépôt prédéterminé est mesuré dans la chambre de préparation.

8. Appareil de fabrication selon la revendication 7, dans lequel une pluralité de chambres de préparation sont disposées de part et d'autre de la chambre de dépôt.

9. Appareil de fabrication selon la revendication 7, dans lequel la chambre de préparation comporte une pluralité de dispositifs de mesure d'épaisseur de film à différentes distances de la source d'évaporation.

10. Appareil de fabrication selon la revendication 1, dans lequel :
l'appareil de dépôt en phase vapeur est configuré pour évaporer le matériau d'évaporation à partir de la source d'évaporation,
dans lequel la source d'évaporation comprend un réservoir pour le matériau d'évaporation et une paroi latérale du réservoir comporte une ouverture pour décharger horizontalement le matériau d'évaporation, et
dans lequel une surface plane ayant un diamètre au minimum égal à celui de l'ouverture est coplanaire avec une surface externe du réservoir.

11. Appareil de fabrication selon la revendication 10, dans lequel le diamètre minimum de l'ouverture dans une surface externe du réservoir est inférieur à un diamètre de l'ouverture dans la surface interne du réservoir.

12. Appareil de fabrication selon la revendication 10, dans lequel la source d'évaporation est entourée par un dispositif de chauffage supérieur et un dispositif de chauffage inférieur, dont les températures peuvent être contrôlées indépendamment.

13. Appareil de fabrication selon la revendication 10, dans lequel une direction de déplacement de la source d'évaporation est orthogonale à une direction de déplacement du substrat.

14. Appareil de fabrication selon l'une quelconque des revendications 4 à 6, comprenant en outre :
une chambre de préparation,
dans lequel la chambre de préparation, où un dispositif de mesure d'épaisseur de film est pourvu, est connectée à la chambre de dépôt, et
dans lequel l'appareil de dépôt en phase vapeur est adapté pour effectuer un dépôt en déplaçant de manière répétée au moins une des sources d'évaporation vers le haut et vers le bas selon la direction de l'axe Z et en déplaçant le substrat selon la direction de l'axe X à intervalles réguliers après qu'un taux de dépôt prédéterminé est mesuré dans la chambre de préparation.

15. Appareil de fabrication selon la revendication 14, dans lequel une pluralité de chambres de préparation sont disposées de part et d'autre de la chambre de dépôt.

16. Appareil de fabrication selon la revendication 14, dans lequel la chambre de préparation comporte une pluralité de dispositifs de mesure d'épaisseur de film à différentes distances de la source d'évaporation.

17. Appareil de fabrication selon la revendication 4, dans lequel :
l'appareil de dépôt en phase vapeur est configuré pour évaporer le matériau d'évaporation à partir des sources d'évaporation,
dans lequel chacune des sources d'évaporation comprend un réservoir propre pour le matériau d'évaporation et chacune des parois latérales des réservoirs comporte une ouverture pour décharger horizontalement le matériau d'évaporation, et
dans lequel chacune des surfaces planes ayant un diamètre au minimum égal à celui des ouvertures est coplanaire avec une surface externe du réservoir.

18. Appareil de fabrication selon la revendication 17, dans lequel le diamètre minimum de l'ouverture dans la surface externe du réservoir est inférieur à un diamètre de l'ouverture dans une surface interne du réservoir.

19. Appareil de fabrication selon la revendication 17, dans lequel la source d'évaporation est entourée par un dispositif de chauffage
supérieur et un dispositif de chauffage inférieur, dont les températures peuvent être contrôlées indépendamment.

20. Appareil de fabrication selon la revendication 17, dans lequel une direction de déplacement de la source d'évaporation est orthogonale à une direction de déplacement du substrat.

21. Procédé de fabrication d'un dispositif à émission lumineuse comprenant les étapes qui consistent à :
procurer un substrat dans une chambre de dépôt perpendiculaire à une face inférieure de la chambre de dépôt ;
procurer une source d'évaporation comportant un matériau d'évaporation à l'opposé du substrat ;
décharger horizontalement le matériau d'évaporation depuis la source d'évaporation vers le substrat durant le déplacement de la source d'évaporation vers le haut et vers le bas selon une direction de l'axe Z ; et
déplacer le substrat selon une direction de l'axe X, qui est orthogonale à la direction de l'axe Z et perpendiculaire à une direction normale au substrat,
moyennant quoi le substrat est déplacé de manière répétée selon la direction de l'axe X à intervalles réguliers après que la source d'évaporation est déplacée vers le haut et vers le bas selon la direction de l'axe Z.
